# EUROPÄISCHE PATENTSCHRIFT

(11) **EP 3 331 688 B1**
(45) Veröffentlichungstag und Bekanntmachung des Hinweises auf die Patenterteilung: **14.06.2023**
(21) Anmeldenummer: 16775452.2
(22) Anmeldetag: 04.08.2016
(51) Int. Cl.: B22F 5/00, B29C 33/70, B22F 5/10, B29C 64/153, B29C 64/393, B22F 10/28, B22F 10/80, B29C 33/38, G06F 30/23, B29C 33/04, B29C 45/33, B33Y 10/00, B33Y 30/00

(54) **VERFAHREN ZUR HERSTELLUNG EINES DREIDIMENSIONALEN OBJEKTS**
METHOD FOR PRODUCING A THREE-DIMENSIONAL OBJECT
PROCÉDÉ DE FABRICATION D'UN OBJET TRIDIMENSIONNEL

(30) Priorität: 06.08.2015 DE 102015112918
(43) Veröffentlichungstag der Anmeldung: 13.06.2018
(73) Patentinhaber: Concept Laser GmbH, 96215 Lichtenfels (DE)
(72) Erfinder: HERZOG, Frank, 96215 Lichtenfels (DE)
(74) Vertreter: Hafner & Kohl PartmbB
(86) Internationale Anmeldenummer: PCT/DE2016/100356
(87) Internationale Veröffentlichungsnummer: WO 2017/020894

(56) Entgegenhaltungen:
- EP-A1- 2 778 992
- US-A- 6 145 804
- US-A1- 2015 190 971
- Mirko Bromberger: "Additive Manufacturing Design & Engineering Symposium Paradigmenwechsel in der Konstruktion und Entwicklung Innovation Intelligence", , 25. November 2014 (2014-11-25), XP055328141, Gefunden im Internet: URL:http://www.altairhyperworks.com/Resour ceLibrary.aspx?keywords=Additive&industry= All&product_service=All&category=All&order _by=date_created&order_by_da=desc [gefunden am 2016-12-12]

## Beschreibung

Die Erfindung betrifft ein Verfahren zur Herstellung eines dreidimensionalen Objekts. Verfahren zur Herstellung dreidimensionaler Objekte, wie z. B. technischer Gegenstände, sind dem Stand der Technik in einer Vielzahl an unterschiedlichen Ausführungen bekannt.

Stetig an Bedeutung gewinnen dabei Verfahren zur generativen Herstellung dreidimensionaler Objekte. Entsprechend herzustellende dreidimensionale Objekte werden durch sukzessives selektives schichtweises Verfestigen eines verfestigbaren Baumaterials in jeweiligen Querschnittsbereichen der jeweils herzustellenden Objekte entsprechenden Bereichen vermittels eines von einer Strahlungserzeugungseinrichtung erzeugten Energiestrahls generativ aufgebaut.

Die geometrisch-konstruktive Ausgestaltung, insbesondere auch das Gewicht, von mit bekannten Verfahren hergestellten dreidimensionalen Objekten ist in der Regel durch vor der eigentlichen Herstellung vorgegebene geometrisch-konstruktive Daten festgelegt. Eine, z. B. auf Grundlage von in einem objektspezifischen Anwendungs- bzw. Einsatzbereich tatsächlich auf das hergestellte Objekt wirkenden Lasten erfolgende, Optimierung der geometrisch-konstruktiven Ausgestaltung des jeweiligen Objekts erfolgt im Rahmen derartiger Verfahren typischerweise nicht. Das Dokument EP-A-2778992 offenbart ein Verfahren zur additiven Herstellung eines Bauteils unter Verwendung von Topologieoptimierung.

Der Erfindung liegt die Aufgabe zugrunde, ein demgegenüber verbessertes Verfahren zur Herstellung eines dreidimensionalen Objekts anzugeben.

Die Aufgabe wird durch ein Verfahren gemäß Anspruch 1 gelöst. Die abhängigen Ansprüche betreffen vorteilhafte Ausführungsformen des Verfahrens. Die Aufgabe wird ferner durch eine Vorrichtung gemäß Anspruch 14 gelöst.

Das hierin beschriebene Verfahren dient im Allgemeinen der Herstellung dreidimensionaler Objekte (im Weiteren abgekürzt als "Objekte" bezeichnet). Die vermittels des Verfahrens herzustellenden bzw. hergestellten Objekte werden bzw. sind zumindest abschnittsweise generativ aufgebaut bzw. hergestellt. Ein vermittels des Verfahrens hergestelltes Objekt kann sonach konventionell, d. h. nicht generativ, aufgebaute Objektabschnitte und generativ aufgebaute Objektabschnitte umfassen.

Selbstverständlich kann ein vermittels des Verfahrens hergestelltes Objekt auch vollständig generativ aufgebaut bzw. hergestellt sein, sodass es ausschließlich generativ aufgebaute Objektabschnitte umfasst.

Der generative Aufbau bzw. die generative Herstellung eines entsprechenden Objekts bzw. Objektabschnitts basiert auf einem sukzessiven selektiven schichtweisen Verfestigen wenigstens eines verfestigbaren Baumaterials in jeweiligen Querschnittsbereichen des jeweils herzustellenden Objekts bzw. Objektabschnitts entsprechenden Bereichen vermittels wenigstens eines von wenigstens einer Strahlungserzeugungseinrichtung erzeugten Energiestrahls. Die sukzessive selektive schichtweise Verfestigung des verfestigbaren Baumaterials erfolgt auf Grundlage von die geometrisch-konstruktive Gestalt, d. h. insbesondere die schichtbezogenen Querschnittsgeometrien, des jeweils herzustellenden Objekts bzw. Objektabschnitts beschreibenden Baudaten. Entsprechende Baudaten beschreiben im Allgemeinen die geometrische bzw. geometrisch-konstruktive Gestalt des jeweils generativ herzustellenden Objekts bzw. Objektabschnitts.

Bei einem im Rahmen des Verfahrens verwendeten verfestigbaren Baumaterial kann es sich z. B. um ein vermittels eines entsprechenden Energiestrahls verfestigbares Metallpulver(gemisch) und/oder um ein vermittels eines entsprechenden Energiestrahls verfestigbares Kunststoffpulver(gemisch) handeln. Ein entsprechend verfestigbares Baumaterial ist typischerweise pulverartig bzw. pulverförmig.

Bei einem im Rahmen des Verfahrens verwendeten Energiestrahl kann es sich um elektromagnetische Strahlung, d. h. z. B. um einen Laserstrahl, kurz einen Laser, handeln. Bei einer im Rahmen des Verfahrens verwendeten Strahlungserzeugungseinrichtung kann es sich sodann um eine Lasererzeugungseinrichtung zur Erzeugung eines Laserstrahls handeln. In diesem Fall kann das Verfahren z. B. ein selektives Lasersinterverfahren, kurz SLS-Verfahren, zur Durchführung selektiver Lasersinterprozesse zur generativen Herstellung dreidimensionaler Objekte oder ein selektives Laserschmelzverfahren, kurz SLM-Verfahren, zur Durchführung selektiver Laserschmelzprozesse zur generativen Herstellung dreidimensionaler Objekte umfassen. Im Rahmen des Verfahrens kann anstelle von elektromagnetischer Strahlung auch Elektronen- bzw. Teilchenstrahlung verwendet werden. Bei einer im Rahmen des Verfahrens verwendeten Strahlungserzeugungseinrichtung handelt es sich sodann um eine Elektronen- bzw.

Teilchenerzeugungseinrichtung zur Erzeugung eines Elektronen- bzw. Teilchenstrahls. Das Verfahren wird durch die Merkmale des Anspruchs 1 definiert.

Das Verfahren umfasst im Allgemeinen die folgenden Verfahrensschritte:
- Vorgabe einer, insbesondere geometrisch-konstruktive, Daten eines Referenzobjekts beschreibenden Referenzobjektinformation sowie wenigstens einer wenigstens eine, insbesondere geometrisch-konstruktive, Randbedingung des herzustellenden Objekts beschreibenden Randbedingungsinformation,
- Ermitteln einer wenigstens einen Lastwert in wenigstens einer bestimmten Lastsituation innerhalb des durch die Referenzobjektinformation beschriebenen Referenzobjekts beschreibenden Lastinformation,
- Ermitteln von Lastbereichen mit von einem vorgebbaren oder vorgegebenen Referenzlastwert abweichenden Lastwerten innerhalb des durch die Referenzobjektinformation beschriebenen Referenzobjekts anhand der Lastinformation,
- Ermitteln einer geometrisch-konstruktive Daten des herzustellenden dreidimensionalen Objekts beschreibenden Objektinformation auf Grundlage der Lastinformation sowie der Randbedingungsinformation,
- Herstellen des herzustellenden Objekts auf Grundlage der Objektinformation, wobei das herzustellende dreidimensionale Objekt zumindest in Lastbereichen mit von dem vorgebbaren oder vorgegebenen Referenzlastwert abweichenden Lastwerten durch sukzessives selektives schichtweises Verfestigen eines verfestigbaren Baumaterials generativ hergestellt wird.

In einem ersten Schritt des Verfahrens wird eine, insbesondere geometrisch-konstruktive, Daten eines Referenzobjekts beschreibende Referenzobjektinformation sowie wenigstens eine wenigstens eine, insbesondere geometrisch-konstruktive, Randbedingung des tatsächlich vermittels des Verfahrens herzustellenden Objekts beschreibende Randbedingungsinformation erstellt bzw. vorgegeben.

Die Referenzobjektinformation beschreibt Daten eines Referenzobjekts. Entsprechende Daten beinhalten insbesondere eine festgelegte geometrisch-konstruktive Ausgestaltung, d. h. insbesondere eine festgelegte Außenkontur, des Referenzobjekts. Die Referenzobjektinformation beschreibt somit insbesondere die geometrisch-konstruktive Ausgestaltung des Referenzobjekts. Die Referenzobjektinformation kann sonach Konstruktionsdaten, z. B. CAD-Daten, des Referenzobjekts beschreiben. Das Referenzobjekt stellt typischerweise ein dem herzustellenden Objekt seiner Gattung nach entsprechendes Objekt dar. Wird, wie weiter unten erläutert, im Rahmen des Verfahrens ein Werkzeugelement eines Spritzgießwerkzeugs hergestellt, stellt das Referenzobjekt bereits ein Werkzeugelement eines Spritzgießwerkzeugs dar.

Die geometrisch-konstruktive Ausgestaltung, d. h. insbesondere auch die Masse, des Referenzobjekts ist typischerweise im Hinblick auf einen objektspezifischen Anwendungs- bzw. Einsatzbereich festgelegt. Entsprechende durch die Referenzobjektinformation beschriebene geometrisch-konstruktive Daten des Referenzobjekts beinhalten eine im Weiteren abzuwandelnde bzw. zu optimierende, typischerweise gattungsgemäße, Grundform des eigentlich herzustellenden Objekts. Die durch die Referenzobjektinformation beschriebene geometrisch-konstruktive Ausgestaltung des Referenzobjekts weicht sonach von der geometrisch-konstruktiven Ausgestaltung des herzustellenden Objekts ab und umgekehrt. Bestimmte geometrisch-konstruktive Parameter des herzustellenden Objekts können sonach mit bestimmten geometrisch-konstruktiven Parametern des Referenzobjekts übereinstimmen, andere geometrisch-konstruktive Parameter des herzustellenden Objekts können von bestimmten geometrisch-konstruktiven Parametern des Referenzobjekts abweichen. Selbstverständlich ist es auch möglich, dass alle geometrisch-konstruktiven Parameter des herzustellenden Objekts von den geometrisch-konstruktiven Parametern des Referenzobjekts abweichen.

Konkret kann eine Referenzobjektinformation z. B. ein massiv ausgebildetes Referenzobjekt mit festgelegten Außenabmessungen bzw. einer festgelegten Außenkontur beschreiben. Die Außenabmessungen bzw. die Außenkontur, d. h. (im Wesentlichen) die äußere Form, des herzustellenden Objekts weicht, wie sich im Weiteren ergibt, verfahrensbedingt zumindest abschnittsweise, gegebenenfalls vollständig, von den Außenabmessungen bzw. der Außenkontur, d. h. (im Wesentlichen) der äußeren Form, des Referenzobjekts ab. Sofern die äußere Form des herzustellenden Objekts nicht vollständig von der äußeren Form des Referenzobjekts abweicht, können die Außenabmessungen bzw. die Außenkontur, d. h. (im Wesentlichen) die äußere Form, des herzustellenden Objekts zumindest abschnittsweise den Außenabmessungen bzw. der Außenkontur, d. h. (im Wesentlichen) der äußeren Form, des Referenzobjekts entsprechen.

Neben der Referenzobjektinformation wird, wie erwähnt, auch wenigstens eine Randbedingungsinformation erstellt bzw. vorgegeben. Die Randbedingungsinformation beschreibt unterschiedliche das herzustellende Objekt betreffende Randbedingungen. Randbedingungen können geometrisch-konstruktive Parameter bzw. strukturelle-physikalische Parameter bzw. Eigenschaften des herzustellenden Objekts sein. Über die Randbedingungsinformation können sonach bestimmte geometrisch-konstruktive Parameter bzw. bestimmte strukturelle-physikalische Parameter bzw. Eigenschaften vorgegeben werden, die an wenigstens einem Objektabschnitt des herzustellenden Objekts bzw. dem gesamten herzustellenden Objekt (zwingend) gegeben sein sollen.

Entsprechende Randbedingungen können wenigstens einen geometrisch-konstruktiven Parameter wenigstens eines äußeren (freiliegenden) Objektabschnitts des herzustellenden Objekts, z. B. einer Oberfläche, einer Seitenfläche, einer Bodenfläche, etc., und/oder wenigstens eines inneren (nicht freiliegenden) Objektabschnitts des herzustellenden Objekts bzw. geometrisch-konstruktive Parameter des gesamten herzustellenden Objekts definieren. Typischerweise definieren entsprechende geometrisch-konstruktive Parameter zumindest die Außenabmessungen bzw. die Außenkontur, d. h. (im Wesentlichen) die äußere Form, wenigstens eines Objektabschnitts des herzustellenden Objekts bzw. des gesamten herzustellenden Objekts.

Entsprechende Randbedingungen können alternativ oder ergänzend wenigstens einen strukturellen-physikalischen Parameter wenigstens eines äußeren (freiliegenden) Objektabschnitts des herzustellenden Objekts und/oder wenigstens eines inneren (nicht freiliegenden) Objektabschnitts des herzustellenden Objekts bzw. wenigstens einen strukturellen-physikalischen Parameter des gesamten herzustellenden Objekts definieren. Entsprechende strukturelle-physikalische Parameter sind insbesondere mechanische Parameter, wie z. B. Masse, Dichte, Härte, Festigkeit bzw. Biegefestigkeit, Steifigkeit bzw. Biegesteifigkeit, Elastizität, Plastizität (Duktilität), Zähigkeit, und/oder tribologische Parameter, wie z. B. Reibzahl, Verschleißwiderstand, und/oder optisch-akustische Parameter, wie z. B. Licht- und/oder Schallabsorption bzw. Licht- und/oder Schallreflexion, und/oder thermische Parameter, wie z. B. thermische Ausdehnung, thermische Leitfähigkeit, (spezifische) Wärmekapazität, Warmfestigkeit, Kaltzähigkeit, und/oder elektrische Parameter, wie z. B. elektrische Leitfähigkeit, elektrischer Widerstand, wenigstens eines Objektabschnitts des herzustellenden Objekts bzw. des gesamten herzustellenden Objekts.

Im Weiteren werden Beispiele bestimmter Randbedingungsinformationen gegeben:
Eine Randbedingungsinformation kann z. B. wenigstens einen im Hinblick auf die durch die Referenzobjektinformation beschriebenen geometrisch-konstruktiven Daten des Referenzobjekts nicht veränderbaren zwei- oder dreidimensionalen Bereich des herzustellenden Objekts beschreiben. Das herzustellende Objekt kann dann mit einem dem durch die Randbedingungsinformation beschriebenen nicht veränderbaren Bereich entsprechenden Bereich hergestellt werden. Die geometrisch-konstruktive Ausgestaltung des Objekts stimmt hier zumindest insoweit mit der geometrisch-konstruktiven Ausgestaltung des Referenzobjekts überein.

Eine Randbedingungsinformation kann ferner eine geschlossene Außenkontur des herzustellenden Objekts beschreiben. Das herzustellende Objekt kann dann mit einer der durch die Randbedingungsinformation beschriebenen geschlossenen Außenkontur entsprechenden geschlossenen Außenkontur hergestellt werden. Die geometrisch-konstruktive Ausgestaltung des Objekts stimmt hier zumindest insoweit mit der geometrisch-konstruktiven Ausgestaltung des Referenzobjekts überein.

Eine Randbedingungsinformation kann ferner wenigstens einen massiv auszubildenden Außen- und/oder Innenbereich des herzustellenden Objekts beschreiben. Das herzustellende Objekt kann dann mit einem dem durch die Randbedingungsinformation beschriebenen massiv auszubildenden Außen- und/oder Innenbereich entsprechenden massiv ausgebildeten Außen- und/oder Innenbereich hergestellt werden. Die geometrisch-konstruktive Ausgestaltung des Objekts stimmt hier zumindest insoweit mit der geometrisch-konstruktiven Ausgestaltung des Referenzobjekts überein.

Eine Randbedingungsinformation kann ferner wenigstens ein im Hinblick auf eine bestimmungsgemäße Verwendung des herzustellenden Objekts objektspezifisches Funktionselement, z. B. ein Verbindungsbereich oder ein Verbindungselement zum Verbinden des Objekts mit einem weiteren Objekt, beschreiben. Das herzustellende Objekt kann mit einem dem wenigstens einen durch die Randbedingungsinformation beschriebenen Funktionselement entsprechenden Funktionselement hergestellt werden. Die geometrisch-konstruktive Ausgestaltung des Objekts stimmt hier zumindest insoweit mit der geometrisch-konstruktiven Ausgestaltung des Referenzobjekts überein. Derart kann sichergestellt werden, dass sich das hergestellte Objekt bestimmungsgemäß mit weiteren Objekten verbinden, d. h. insbesondere auch in weitere Objekte einfügen, lässt.

In einem auf den ersten Schritt folgenden zweiten Schritt des Verfahrens wird eine wenigstens einen Lastwert in wenigstens einer bestimmten Lastsituation, insbesondere wenigstens einer Lastsituation bei bestimmungsgemäßer Verwendung des herzustellenden Objekts, innerhalb des durch die Referenzobjektinformation beschriebenen Referenzobjekts beschreibende Lastinformation ermittelt. Die Lastinformation beschreibt sonach Lastwerte, welche wenigstens ein Referenzobjektabschnitt bzw. das gesamte Referenzobjekt in bestimmten Lastsituationen erfährt, und somit das Verhalten ("Lastverhalten") wenigstens eines Referenzobjektabschnitts bzw. des gesamten Referenzobjekts in bestimmten Lastsituationen. Bei entsprechenden Lastsituationen kann es sich z. B. um bestimmungsgemäße Lastszenarien des herzustellenden Objekts, d. h. Lastsituationen, welchen das herzustellende Objekt bei bestimmungsgemäßer Verwendung typischerweise ausgesetzt ist, handeln. Selbstverständlich ist es ebenso möglich, dass es sich bei entsprechenden Lastsituationen um unabhängig von der bestimmungsgemäßen Verwendung des herzustellenden Objekts erzeugte Lastszenarien handelt.

Die Lastinformation kann im Allgemeinen eine mechanische und/oder eine klimatische und/oder eine strömungstechnische und/oder eine thermische Lastsituation, insbesondere bei bestimmungsgemäßer Verwendung des herzustellenden Objekts, beschreiben. Eine entsprechende Lastsituation kann auch eine zumindest abschnittsweise Verteilung jeweiliger Lasten innerhalb des Objekts beinhalten.

Die Lastinformation kann durch geeignete Algorithmen, vermittels einer rechnerbasierten Simulation, z. B. einer FEM-Simulation, erstellt werden. Mit anderen Worten kann die Lastinformation Daten einer Simulation, z. B. einer FEM-Simulation, beinhalten.

In einem auf den zweiten Schritt folgenden dritten Schritt des Verfahrens werden Lastbereiche mit von einem vorgebbaren oder vorgegebenen Referenzlastwert abweichenden Lastwerten innerhalb des durch die Referenzobjektinformation beschriebenen Referenzobjekts anhand der Lastinformation bzw. in der Lastinformation ermittelt. Die in dem zweiten Schritt des Verfahrens ermittelten Lastwerte innerhalb des wenigstens einen Referenzobjektabschnitts bzw. innerhalb des gesamten Referenzobjekts in der jeweils betrachteten Lastsituation werden sonach einzeln, gruppenweise oder vollständig mit wenigstens einem Referenzlastwert verglichen. Es wird sonach durch Ab- bzw. Vergleich insbesondere ermittelt, ob entsprechende Lastwerte innerhalb des wenigstens einen Referenzobjektabschnitts bzw. innerhalb des gesamten Referenzobjekts oberhalb oder unterhalb eines entsprechenden Referenzlastwerts liegen, mithin einen entsprechenden Referenzlastwert über- oder unterschreiten. Unter einem Referenzlastwert kann ein oberer und/oder unterer Lastgrenzwert zu verstehen sein. Obere bzw. untere Lastgrenzwerte sind typischerweise durch objektspezifische, insbesondere materialspezifische, Kennwerte definiert.

Das Ermitteln entsprechender Lastbereiche mit von einem Referenzlastwert abweichenden Lastwerten innerhalb des durch die Referenzobjektinformation beschriebenen Referenzobjekts anhand der Lastinformation bzw. in der Lastinformation kann durch geeignete Algorithmen, vermittels einer rechnerbasierten Simulation, z. B. einer FEM-Simulation, erfolgen.

In einem auf den dritten Schritt folgenden vierten Schritt des Verfahrens wird auf Grundlage der Lastinformation sowie der Randbedingungsinformation eine geometrisch-konstruktive Daten des herzustellenden Objekts beschreibende Objektinformation ermittelt. Entsprechende geometrisch-konstruktive Daten beinhalten insbesondere die geometrisch-konstruktive Ausgestaltung des herzustellenden Objekts. Die Objektinformation beschreibt somit insbesondere die geometrisch-konstruktive Ausgestaltung des herzustellenden Objekts. In die geometrisch-konstruktive Ausgestaltung des herzustellenden Objekts gehen durch die Randbedingungsinformation beschriebene Randbedingungen, d. h. z. B. zwingend an dem herzustellenden Objekt vorzusehende geometrisch-konstruktive Parameter, wie z. B. eine zwingende geometrisch-konstruktive äußere Gestaltung, des Objekts, und/oder zwingend an dem herzustellenden Objekt vorzusehende strukturelle-physikalische Parameter, wie z. B. zwingende mechanische Eigenschaften des Objekts, ein Maximalgewicht des Objekts, etc. ein. Gleichermaßen gehen die durch die Lastinformation beschriebenen Lastwerte in die Objektinformation ein.

Die Objektinformation kann sonach Konstruktionsdaten, z. B. CAD-Daten, des herzustellenden Objekts beschreiben. Diese Konstruktionsdaten werden typischerweise in die geometrisch-konstruktive Gestalt, d. h. insbesondere die schichtbezogenen Querschnittsgeometrien, des jeweils herzustellenden Objekts bzw. Objektabschnitts beschreibende Baudaten umgesetzt.

In einem auf den vierten Schritt folgenden fünften Schritt des Verfahrens wird das herzustellende Objekt auf Grundlage der Objektinformation hergestellt. Das herzustellende Objekt wird dabei zumindest in den Lastbereichen mit von dem Referenzlastwert abweichenden Lastwerten durch sukzessives selektives schichtweises Verfestigen eines verfestigbaren Baumaterials generativ hergestellt. Wenigstens diejenigen Bereiche des herzustellenden bzw. hergestellten Objekts, welche den ermittelten Lastbereichen des Referenzobjekts, in welchen Lastwerte von entsprechenden Referenzlastwerten abweichen, d. h. diese unter- oder überschreiten, entsprechen, werden sonach generativ aufgebaut. Selbstverständlich kann, wie erwähnt, auch das gesamte Objekt generativ aufgebaut werden.

Durch den generativen Aufbau wenigstens jeweiliger Bereiche des herzustellenden bzw. hergestellten Objekts, welche den Lastbereichen des Referenzobjekts, in welchen Lastwerte von entsprechenden Referenzlastwerten abweichen, entsprechen, können in diesen generativ aufgebauten Bereichen des Objekts besondere äußere und/oder innere Strukturen ausgebildet werden, welche der jeweiligen Abweichung der jeweiligen Lastwerte von entsprechenden Referenzlastwerten Rechnung tragen. Dieses Prinzip wird anhand nachfolgender Beispiele exemplarisch veranschaulicht:
In Bereichen des Objekts, welche entsprechenden Lastbereichen des Referenzobjekts entsprechen, welche bestimmte mechanische, Referenzlastwerte, z. B. untere Grenzwerte, wie z. B. eine Mindeststeifigkeit, unterschreiten würden, können generativ gezielt Strukturen ausgebildet werden, die eine (lokale) mechanische Verstärkung, z. B. eine mechanische Versteifung, des Objekts bewirken. In Bereichen des Objekts, welche entsprechenden Lastbereichen des Referenzobjekts entsprechen, welche bestimmte mechanische, Referenzlastwerte, z. B. obere Grenzwerte, bereits überschreiten, können generativ gezielt Strukturen ausgebildet werden, die z. B. eine (lokale) Gewichts- bzw. Materialreduzierung (im Vergleich zu einer massiven Ausbildung des Objekts) bewirken.

In Bereichen des Objekts, welche entsprechenden Lastbereichen des Referenzobjekts entsprechen, welche bestimmte thermische Referenzlastwerte, z. B. obere Grenzwerte, wie z. B. eine maximale Betriebstemperatur, überschreiten würden, können generativ gezielt Temperierkanalstrukturen ausgebildet werden, die eine (lokale) Temperierung, hier Kühlung, des Objekts erlauben. In Bereichen des Objekts, welche entsprechenden Lastbereichen des Referenzobjekts entsprechen, welche bestimmte thermische Referenzlastwerte, z. B. untere Grenzwerte, wie z. B. eine minimale Betriebstemperatur, unterschreiten würden, können generativ gezielt Temperierkanalstrukturen ausgebildet werden, die eine (lokale) Temperierung, hier Erwärmung, des Objekts erlauben.

Anhand der Beispiele lässt sich ein besonderer Vorteil des Verfahrens erkennen, welches es sonach ermöglicht, bestimmte Objektabschnitte bzw. das gesamte Objekt, insbesondere im Hinblick auf bestimmte Lastsituationen des Objekts, gezielt generativ, d. h. insbesondere mit generativ ausgebildeten Strukturen, herzustellen. Dem Aufbau jeweiliger Objektabschnitte bzw. des Objekts wird die vorherige Ermittlung bestimmter Lastbereiche in dem Referenzobjekt zugrunde gelegt, welche, wie beschrieben, im Hinblick auf bestimmte Referenzlastwerte ausgewertet, d. h. mit entsprechenden Referenzlastwerten verglichen, wurden. Derart können - bezogen auf eine bestimmte Lastsituation - Bereiche ermittelt werden, welche im Hinblick auf die bestimmte Lastsituation besonders, d. h. z. B. mit besonderen Strukturen, d. h. insbesondere optimiert, ausgebildet werden. Hierunter kann, wie erwähnt, z. B. eine Ausbildung von mechanischen Verstärkungsstrukturen und/oder eine Ausbildung von mechanischen Schwächungsstrukturen, d. h. z. B. Gewicht- bzw. Materialeinsparungsstrukturen und/oder eine Ausbildung von Temperierkanalstrukturen, etc. verstanden werden.

Das herzustellende Objekt kann sonach im Hinblick auf eine bestimmte Anwendungssituation bzw. eine bestimmte Lastsituation optimiert werden, was die strukturellen Eigenschaften des Objekts unter verschiedenen Gesichtspunkten, z. B. mechanische Stabilität, Gewicht, etc., erheblich verbessert. Dabei ist es insbesondere möglich, dass eine entsprechende Optimierung nur im Inneren des Objekts erfolgt. Die Außenabmessungen bzw. die Außenkontur, d. h. (im Wesentlichen) die äußere Form, des Objekts kann (im Vergleich zu dem Referenzobjekt) beibehalten werden.

Ein weiterer Vorteil des Verfahrens liegt darin, dass verfahrensgemäß herzustellende dreidimensionale Objekte vollständig generativ aufgebaut werden können. Insbesondere im Hinblick auf die Herstellung von technischen Objekten, d. h. Werkzeugelementen für Spritzgießwerkzeuge, wie z. B. Werkzeugeinsatzelemente, Schieberelemente, etc., welche bis dato einen in einem Lager vorzuhaltenden Grundobjektkörper umfassen, welcher im Weiteren mit wenigstens einem generativ auf dem Grundobjektkörper aufgebauten Objektabschnitt versehen wird ("Hybridobjekt"), kann durch die direkte generative Herstellung des Objekts Lagerplatz, Lagerzeit, Lagerarbeiten, etc. eingespart werden.

Ein weiterer Vorteil des Verfahrens ist entsprechend auch die Möglichkeit eines sparsamen Umgangs mit Ressourcen, d. h. insbesondere Baumaterial. Derart ist eine gute bzw. verbesserte Energiebilanz des Verfahrens ("CO₂-Footprint") möglich.

Die oder einzelne der oben genannten Verfahrensschritte können unmittelbar nacheinander durchgeführt werden. Denkbar ist auch, dass die oder einzelne Verfahrensschritte mittelbar, d. h. unter Zwischenschaltung von anderen Verfahrensschritten und/oder von Verfahrensunterbrechungen, nacheinander durchgeführt werden.

Eine Ausführungsform des Verfahrens sieht vor, dass das herzustellende Objekt in Lastbereichen mit von dem Referenzlastwert abweichenden Lastwerten mit einer durch sukzessives selektives schichtweises Verfestigen des verfestigbaren Baumaterials vermittels des von der Strahlungserzeugungseinrichtung erzeugten Energiestrahls generativ gebildeten, wenigstens ein Leichtbauelement umfassenden Leichtbaustruktur hergestellt wird. Durch die gezielte generative Ausbildung entsprechender Leichtbaustrukturen kann das Objekt in Bereichen, welche entsprechenden Lastbereichen des Referenzobjekts entsprechen, welche bestimmte Referenzlastwerte über- oder unterschreiten, gezielt mit generativ ausgebildeten Strukturen hergestellt werden, die, z. B., z. B. durch eine (lokale) Dichtereduzierung, eine Gewichts- bzw. Materialreduzierung bewirken. Leichtbaustrukturen werden typischerweise in mechanisch kaum beanspruchten Bereichen des Objekts ausgebildet. Durch die generative Ausbildung entsprechender Leichtbaustrukturen sind diese in beliebigen geometrisch-konstruktiven Ausgestaltungen, insbesondere Querschnittsgeometrien, ausbildbar und können sich beliebig durch das Objekt erstrecken.

Als Leichtbauelement einer entsprechenden Leichtbaustruktur kann z. B. eine Aussparung, eine Sandwichstruktur, ein Bereich mit einer im Vergleich zu übrigen Bereichen des hergestellten Objekts geringeren Dichte, ein Bereich aus einem im Vergleich zu einem übrigen verfestigbaren Baumaterial des hergestellten Objekts eine geringere Dichte aufweisenden verfestigbaren Baumaterial oder ein Bereich mit einer im Vergleich zu übrigen Bereichen des hergestellten Objekts geringeren Wandstärke gebildet werden. Eine entsprechende Sandwichstruktur besteht typischerweise aus wenigstens einer zwischen wenigstens zwei Lagen höherer mechanischer Stabilität angeordneten oder ausgebildeten Lage geringerer mechanischer Stabilität. Die Lage geringerer mechanischer Stabilität kann beispielsweise zellular ausgebildet sein.

Das Verfahrens sieht vor, dass das herzustellende Objekt in Lastbereichen mit von dem Referenzlastwert abweichenden Lastwerten mit einer durch sukzessives selektives schichtweises Verfestigen des verfestigbaren Baumaterials vermittels des von der Strahlungserzeugungseinrichtung erzeugten Energiestrahls generativ gebildeten Temperierkanalstruktur, welche von einem Temperiermedium, allgemein einem Temperierfluid (Gas und/oder Flüssigkeit), zum Temperieren des hergestellten Objekts durchströmbar ist, hergestellt wird. Eine Temperierkanalstruktur umfasst wenigstens einen sich zumindest abschnittsweise durch wenigstens einen Objektabschnitt erstreckenden Temperierkanal. Durch die gezielte generative Ausbildung entsprechender Temperierkanalstrukturen kann das Objekt in Bereichen, welche entsprechenden (thermischen) Lastbereichen des Referenzobjekts entsprechen, welche bestimmte (thermische) Referenzlastwerte über- oder unterschreiten, gezielt mit generativ ausgebildeten Strukturen hergestellt werden, die von einem Temperiermedium durchströmt eine Temperierung des Objekts bewirken. Temperierkanalstrukturen werden typischerweise in thermisch beanspruchten Bereichen des Objekts ausgebildet. Über entsprechende Temperierkanalstrukturen kann eine gezielte Temperierung, d. h. Kühlung oder Erwärmung, bestimmter Objektabschnitte bzw. des gesamten Objekts realisiert werden. Durch die generative Ausbildung entsprechender Temperierkanalstrukturen sind diese in beliebigen geometrisch-konstruktiven Ausgestaltungen, insbesondere Querschnittsgeometrien, ausbildbar und können sich beliebig, beispielsweise mäanderartig, durch das Objekt erstrecken.

Eine weitere Ausführungsform des Verfahrens sieht vor, dass das herzustellende Objekt in Lastbereichen mit von dem Referenzlastwert abweichenden Lastwerten mit einer durch sukzessives selektives schichtweises Verfestigen des verfestigbaren Baumaterials vermittels des von der Strahlungserzeugungseinrichtung erzeugten Energiestrahls generativ gebildeten, wenigstens ein Versteifungselement umfassenden Versteifungsstruktur hergestellt wird. Durch die gezielte generative Ausbildung entsprechender Versteifungsstrukturen, allgemein entsprechender Strukturen zur Erhöhung der mechanischen Stabilität des Objekts, kann das Objekt in Bereichen, welche entsprechenden (mechanischen) Lastbereichen des Referenzobjekts entsprechen, welche bestimmte (mechanische) Referenzlastwerte über- oder unterschreiten, gezielt mit generativ ausgebildeten Strukturen hergestellt werden, die, z. B. durch eine (lokale) Versteifung, eine Erhöhung der mechanischen Stabilität des Objekts bewirken. Versteifungsstrukturen werden typischerweise in mechanisch beanspruchten Bereichen des Objekts ausgebildet. Durch die generative Ausbildung entsprechender Versteifungsstrukturen sind diese in beliebigen geometrisch-konstruktiven Ausgestaltungen, insbesondere Querschnittsgeometrien, ausbildbar und können sich beliebig durch das Objekt erstrecken.

Als Versteifungsbauelement kann z. B. ein Verrippungselement gebildet werden. Eine Versteifungsstruktur kann z. B. als zwei- oder dreidimensionale Längs- und/oder Querverrippung gebildet werden.

Im Allgemeinen können sich generativ gebildete Strukturen, d. h. insbesondere Leichtbaustrukturen und/oder Temperierkanalstrukturen und/oder Versteifungsstrukturen und/oder bionische Strukturen, zwei- oder dreidimensional, gegebenenfalls netzwerkartig, durch wenigstens einen Objektabschnitt oder das gesamte Objekt erstrecken. Entsprechende generativ gebildete Strukturen können sich (nur) durch das Innere des Objekts erstrecken, so dass sie von außen nicht sichtbar sind. Entsprechende Strukturen können neben ihrer jeweils originären Funktion selbstverständlich auch (weitere) strukturelle-physikalische Eigenschaften des Objekts beeinflussen. Dies kann z. B. bei einer, gegebenenfalls dreidimensionalen, Rippenstruktur innerhalb des Objekts gegeben sein, welche einerseits (im Vergleich zu einer massiven Ausbildung) eine Materialreduktion und andererseits eine mechanische Versteifung des Objekts bedingt.

Selbstverständlich können entsprechende Leichtbaustrukturen mit entsprechenden Temperierkanalstrukturen und/oder mit entsprechenden Versteifungsstrukturen beliebig kombiniert werden.

Eine weitere Ausführungsform des Verfahrens sieht vor, dass das herzustellende Objekt in Lastbereichen mit von dem Referenzlastwert abweichenden Lastwerten mit einer durch sukzessives selektives schichtweises Verfestigen des verfestigbaren Baumaterials vermittels des von der Strahlungserzeugungseinrichtung erzeugten Energiestrahls generativ gebildeten, wenigstens ein bionisches Element, welches wenigstens eine biologische, insbesondere tierische und/oder pflanzliche, Struktur beschreibt und/oder aus wenigstens einer biologischen, insbesondere tierischen und/oder pflanzlichen, Struktur abgeleitet ist, umfassenden bionischen Struktur hergestellt wird.

Im Rahmen des Verfahrens können im Hinblick auf bestimmte Eigenschafts- bzw. Lastanforderungen des jeweils herzustellenden Objekts bestimmte "biologische Vorbilder", welche sich in der Natur in identischen, ähnlichen oder vergleichbaren Lastsituationen bewährt haben, ausgewählt, gegebenenfalls, z. B. im Hinblick auf eine konkrete Eigenschafts- bzw. Lastanforderungen eines herzustellenden Objekts, abgewandelt, und in dem jeweils herzustellenden bzw. hergestellten Objekt generativ ausgebildet werden. Diese, gegebenenfalls abgewandelten, "biologischen Vorbilder" werden durch bionische Daten beschrieben. Die bionischen Daten beschreiben sonach biologische Strukturen und/oder aus biologischen Strukturen abgeleitete Strukturen.

Die bionischen Daten können datenmäßig mit weiteren Baudaten des jeweils herzustellenden Objekts, welche weiteren Baudaten keine biologischen Strukturen beschreiben, verbunden werden, sodass die der sukzessiven selektiven schichtweisen Verfestigung des jeweiligen verfestigbaren Baumaterials zugrunde liegenden Baudaten insgesamt (auch) bionische Daten beinhalten. Die in jeweiligen bionischen Daten beschriebenen Strukturen können so in dem jeweils herzustellenden Objekt zumindest in abgewandelter Form ausgebildet werden.

Die durch die bionischen Daten beschriebenen Strukturen dienen typischerweise als Konstruktionselemente und ermöglichen eine, insbesondere im Hinblick auf bestimmte Eigenschafts- bzw. Lastanforderungen maßgeschneiderte, gezielte Beeinflussung bzw. Einstellung der bzw. bestimmter Eigenschaften eines jeweils herzustellenden Objekts. Mit anderen Worten können durch die Ausbildung entsprechender biologischer Strukturen bzw. aus entsprechenden biologischen Strukturen abgeleiteter Strukturen in einem jeweils herzustellenden bzw. hergestellten Objekt bestimmte Eigenschaften des jeweils herzustellenden bzw. hergestellten Objekts, insbesondere im Hinblick auf bestimmte Eigenschafts- bzw. Lastanforderungen maßgeschneidert, gezielt beeinflusst bzw. eingestellt werden. Durch die Ausbildung entsprechender biologischer Strukturen bzw. aus entsprechenden biologischen Strukturen abgeleiteter Strukturen in einem herzustellenden bzw. hergestellten Objekt können beispielsweise die mechanischen und/oder thermischen und/oder strömungstechnischen Eigenschaften respektive die mechanische und/oder thermische Stabilität zumindest eines Bereichs eines jeweils herzustellenden bzw. hergestellten Objekts gezielt beeinflusst bzw. eingestellt werden.

Unter aus entsprechenden biologischen Strukturen abgeleiteten bzw. abgewandelten biologischen Strukturen sind Strukturen zu verstehen, welche ein biologisches Vorbild nicht naturgetreu, sondern zumindest zum Teil abgewandelt abbilden. Beispielhaft sei in diesem Zusammenhang ein Skelett eines Flügels eines Vogels als biologische Struktur genannt, welches einzelne Skelettelemente, d. h. insbesondere Knochen, in einer bestimmten Anzahl, Anordnung, Ausrichtung, etc. mit bestimmten geometrischen Abmessungen aufweist. Eine Abwandlung dieser biologischen Struktur wäre z. B. eine Änderung der Anzahl und/oder Anordnung und/oder Ausrichtung und/oder der geometrischen Abmessungen wenigstens eines Skelettelements. Analoges gilt selbstverständlich für sämtliche durch entsprechende bionische Daten beschriebene biologische Strukturen.

Biologische Strukturen können tierische und/oder tierisch erzeugte Strukturen und/oder pflanzliche Strukturen und/oder pflanzlich erzeugte Strukturen sein. Biologische Strukturen können auch aus tierischen und/oder tierisch erzeugten und/oder pflanzlichen und/oder pflanzlich erzeugten Strukturen abgeleitete bzw. abgewandelte Strukturen sein. Prinzipiell ist es auch denkbar, dass bionische Daten menschliche Strukturen und/oder aus menschlichen Strukturen abgeleitete Strukturen beschreiben. In diesem Zusammenhang ist jedoch anzumerken, dass die bionischen Daten nur ein Teil entsprechender Baudaten sind, sodass die Baudaten typischerweise nicht der generativen Herstellung von Objekten zu einem identischen Nachbau menschlicher Strukturen, d. h. z. B. zum Zahnersatz, zugrunde gelegt werden.

Entsprechende bionische Daten können, wie erwähnt, tierische Strukturen beschreiben. Im Allgemeinen können als tierische Strukturen äußere und/oder innere Tierstrukturen, insbesondere Gewebestrukturen und/oder Panzerstrukturen und/oder Skelettstrukturen und/oder Oberflächenstrukturen und/oder Zellstrukturen, verwendet werden. Tierische Strukturen können also z. B. äußere und/oder innere Panzerstrukturen und/oder Skelettstrukturen eines Tieres oder eines Teils eines Tiers sein. Beispielhaft wird in diesem Zusammenhang auf bestimmte Extremitäten bzw. Gliedmaßen bzw. Teile bestimmter Extremitäten bzw. Gliedmaßen eines bestimmten Tiers verwiesen. Konkretes Beispiel ist das Skelett des Flügels eines Vogels, welches aufgrund einer bestimmten Anzahl, Anordnung, Ausrichtung und Ausbildung bestimmter Knochenstrukturen besondere mechanische Eigenschaften aufweist. Tierische Strukturen können auch Oberflächenstrukturen eines Tiers sein. Beispielhaft wird in diesem Zusammenhang auf bestimmte Fell-, Gefieder-, Schuppen- oder Hautstrukturen eines bestimmten Tiers verwiesen. Konkretes Beispiel ist die Schuppenstruktur eines Haifischs, welche aufgrund einer bestimmten Anordnung und Ausbildung einzelner Schuppen u. a. besondere strömungstechnische Eigenschaften aufweist.

Entsprechende bionische Daten können auch tierisch erzeugte Strukturen beschreiben. Im Allgemeinen können als tierisch erzeugte Strukturen äußere und/oder innere Strukturen eines tierisch erzeugten Gegenstands, d. h. z. B. eines tierisch erzeugten Bauwerks und/oder eines tierisch erzeugten, insbesondere-, gewebe- oder netzartigen, Textils, verwendet werden. Beispielhaft wird in diesem Zusammenhang auf bestimmte tierisch erzeugte Gebilde bzw. Teile bestimmter tierisch erzeugter Gebilde verwiesen. Konkretes Beispiel ist eine einer von Spinnen erzeugten Spinnennetzstruktur nachempfundene Netzstruktur, eine einer von Seidenraupen erzeugten Seidenfadenstruktur nachempfundene Fadenstruktur, eine einer von Termiten erzeugten Termitenbauwerkstruktur nachempfundene Baustruktur oder eine einer von Bienen erzeugten Wabenstruktur nachempfundene Wabenstruktur, welche jeweils besondere mechanische und/oder (insbesondere für das Beispiel eines Termitenbauwerks, welcher typischerweise eine bestimmte Lüftungs- bzw. Kühlkanalstruktur aufweist) strömungstechnische Eigenschaften aufweisen.

Entsprechende bionische Daten können auch pflanzliche Strukturen beschreiben. Im Allgemeinen können als pflanzliche Strukturen äußere und/oder innere Pflanzenstrukturen, insbesondere Gewebestrukturen und/oder Pflanzenskelettstrukturen und/oder Oberflächenstrukturen und/oder Zellstrukturen, verwendet werden. Beispielhaft wird in diesem Zusammenhang auf bestimmte Pflanzengebilde bzw. Pflanzengebildefortsätze bzw. Teile bestimmter Pflanzengebilde bzw. Pflanzengebildefortsätze verwiesen. Konkretes Beispiel ist eine Ast- oder Blattstruktur eines bestimmten Gewächses, welche aufgrund einer bestimmten Anordnung und Ausbildung bestimmter Rippenstrukturen, d. h. einer sich in Ast- oder Blattlängsrichtung erstreckenden Hauptrippe und davon abzweigenden Seitenrippen, besondere mechanische Eigenschaften aufweist. Pflanzliche Strukturen können, wie erwähnt, auch Oberflächenstrukturen einer Pflanze sein. Beispielhaft wird in diesem Zusammenhang auf bestimmte Oberflächen einer Blatt- oder Stammstruktur eines bestimmten Gewächses verwiesen. Konkretes Beispiel ist die Nachempfindung einer Oberflächenstruktur des Blattes der Lotospflanze, welche aufgrund einer bestimmten Mikro- bzw. Nanostrukturierung besondere die Anhaftung von Schmutzpartikeln verhindernde bzw. Wasser abweisende Eigenschaften aufweist.

Entsprechende bionische Daten können auch pflanzlich erzeugte Strukturen beschreiben. Im Allgemeinen können als pflanzlich erzeugte Strukturen äußere und/oder innere Strukturen eines pflanzlich erzeugten Gegenstands, d. h. z. B. einer pflanzlich erzeugten Frucht, verwendet werden. Beispielhaft wird in diesem Zusammenhang auf pflanzlich erzeugte Gebilde bzw. Teile bestimmter pflanzlich erzeugter Gebilde verwiesen. Konkretes Beispiel ist eine einer von Flachs- oder Hanfpflanzen erzeugten faserigen bzw. textilen Struktur nachempfundene faserige bzw. textile Struktur, welche besondere mechanische Eigenschaften aufweist. Selbstverständlich können entsprechende bionische Daten unterschiedliche tierische Strukturen und/oder pflanzliche Strukturen respektive unterschiedliche tierisch erzeugte Strukturen und/oder pflanzlich erzeugte Strukturen beschreiben. Selbstverständlich können die vorgenannten Strukturen, d. h. Leichtbaustrukturen, Temperierkanalstrukturen, Versteifungsstrukturen, auf Grundlage entsprechender bionischer Daten generativ gebildet werden.

Das Objekt ist ein Werkzeugelement eines Spritzgießwerkzeugs, insbesondere ein Schieberelement oder ein Werkzeugeinsatzelement. Vermittels des Verfahrens kann sonach ein entsprechendes Werkzeugelement eines Spritzgießwerkzeugs hergestellt werden.

Die Erfindung betrifft ferner eine Vorrichtung nach Anspruch 14 zur generativen Herstellung eines dreidimensionalen Objekts durch selektive schichtweise Verfestigung eines verfestigbaren Baumaterials vermittels eines von einer Strahlungserzeugungseinrichtung erzeugten Energiestrahls. Die Vorrichtung ist zur Durchführung des vorstehend beschriebenen Verfahrens ausgebildet. Sämtliche Ausführungen im Zusammenhang mit dem Verfahren gelten sonach analog für die Vorrichtung.

Die Erfindung ist anhand von Ausführungsbeispielen in den Zeichnungsfiguren näher erläutert. Dabei zeigen:
- Fig. 1: eine Prinzipdarstellung einer Vorrichtung zur Durchführung eines Verfahrens gemäß einem Ausführungsbeispiel der Erfindung; und
- Fig. 2 - 7: je eine Prinzipdarstellung eines Verfahrensschritts eines Verfahrens gemäß einem Ausführungsbeispiel der Erfindung.

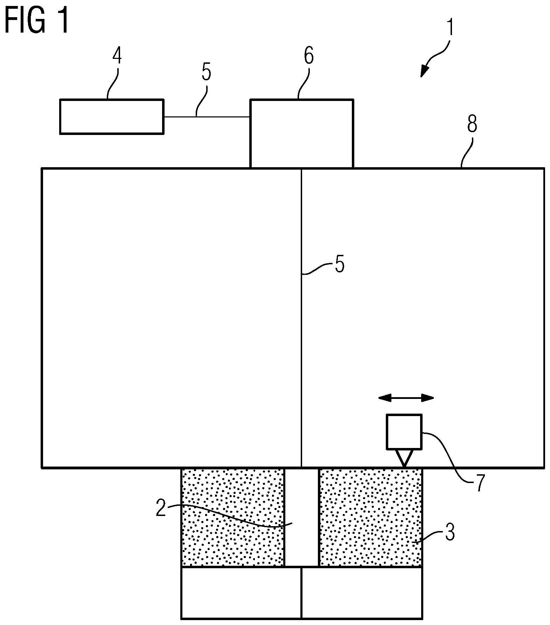

Fig. 1 zeigt eine Prinzipdarstellung einer Vorrichtung 1 zur Durchführung eines Verfahrens gemäß einem Ausführungsbeispiel der Erfindung. Die Vorrichtung 1 und somit das mit dieser durchführbare Verfahren dient der generativen Herstellung eines dreidimensionalen Objekts 2, d. h. typischerweise eines technischen Bauteils bzw. einer technischen Bauteilgruppe, durch sukzessives selektives schichtweises Verfestigen eines verfestigbaren Baumaterials 3 vermittels eines von einer Strahlungserzeugungseinrichtung 4 erzeugten Energiestrahls 5.

Die sukzessive selektive schichtweise Verfestigung des verfestigbaren Baumaterials 3 erfolgt derart, dass der von der Strahlungserzeugungseinrichtung 4 erzeugte Energiestrahl 5 über eine Strahlablenkeinrichtung 6 gezielt auf bestimmte zu verfestigende, jeweiligen schichtbezogenen Querschnittsgeometrien des herzustellenden Objekts 2 entsprechende Bereiche einer vermittels einer, wie durch den horizontal ausgerichteten Pfeil angedeutet, bewegbar gelagerten Beschichtungseinrichtung 7 gebildeten Baumaterialschicht in einer Baukammer 8 der Vorrichtung 1 gelenkt wird.

Die schichtweise selektive Verfestigung des verfestigbaren Baumaterials 3 und sonach der generative Aufbau des Objekts 2 erfolgt dabei auf einer Trageinrichtung mit einem in vertikaler Richtung bewegbar gelagerten Träger. Der Träger ist z. B. relativ zu der Strahlungserzeugungseinrichtung 4 bewegbar gelagert.

Bei dem verwendeten Energiestrahl 5 handelt es sich um elektromagnetische Strahlung, d. h. um einen Laserstrahl, kurz einen Laser. Bei der verwendeten Strahlungserzeugungseinrichtung 4 handelt es sich sonach um eine Lasererzeugungseinrichtung zur Erzeugung eines Laserstrahls. Das Verfahren kann sonach ein selektives Lasersinterverfahren, kurz SLS-Verfahren, zur Durchführung selektiver Lasersinterprozesse zur generativen Herstellung dreidimensionaler Objekte 2 oder ein selektives Laserschmelzverfahren, kurz SLM-Verfahren, zur Durchführung selektiver Laserschmelzprozesse zur generativen Herstellung dreidimensionaler Objekte 2 sein.

Bei dem verwendeten verfestigbaren Baumaterial 3 kann es sich z. B. um ein vermittels des Energiestrahls 5 verfestigbares Metallpulver(gemisch), d. h. z. B. um ein Aluminium- oder Stahlpulver, und/oder um ein vermittels des Energiestrahls 5 verfestigbares Kunststoffpulver(gemisch), d. h. z. B. um ein Polyetheretherketonpulver, handeln.

Selbstverständlich weist die Vorrichtung 1 neben den oben genannten Funktionskomponenten, d. h. der Strahlungserzeugungseinrichtung 4, der Strahlablenkeinrichtung 6 sowie der Beschichtungseinrichtung 7 weitere nicht gezeigte - da für die Erläuterung des hierin beschriebenen Prinzips nicht wesentlich - Funktionskomponenten, welche typischerweise zur Durchführung generativer Bauprozesse erforderlich bzw. zweckmäßig sind, auf.

Die schichtweise selektive Verfestigung des verfestigbaren Baumaterials 3 erfolgt auf Grundlage von Baudaten. Die Baudaten beschreiben im Allgemeinen die geometrische bzw. geometrisch-konstruktive Gestalt des jeweils generativ herzustellenden Objekts 2. Die Baudaten sind zumindest in einer der Vorrichtung 1 zugehörigen Steuereinrichtung (nicht gezeigt) hinterlegt, welche den jeweiligen generativen Bauprozess bzw. die für den jeweiligen generativen Bauprozess erforderlichen Funktionskomponenten der Vorrichtung 1 steuert.

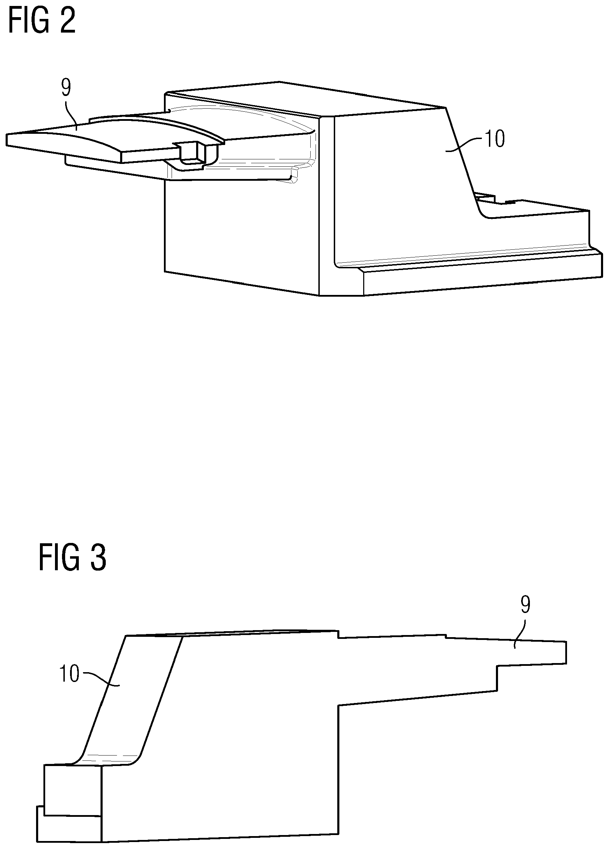

Ein Ausführungsbeispiel des Verfahrens, bei welchem ein Objekt 2 in Form eines Werkzeugschieberelements für ein Spritzgießwerkzeug hergestellt wird, wird anhand der Fig. 2 - 7 näher erläutert.

In dem ersten Schritt des Verfahrens wird eine Daten eines in Fig. 2 gezeigten, massiv ausgebildeten Referenzobjekts beschreibende Referenzobjektinformation sowie eine wenigstens eine, insbesondere geometrisch-konstruktive, Randbedingung des tatsächlich vermittels des Verfahrens herzustellenden Objekts 2 beschreibende Randbedingungsinformation erstellt bzw. vorgegeben. Die Referenzobjektinformation beschreibt Daten des Referenzobjekts.

Entsprechende Daten beinhalten eine festgelegte geometrisch-konstruktive Ausgestaltung, d. h. insbesondere eine festgelegte Außenkontur, des Referenzobjekts. Die Referenzobjektinformation beschreibt somit die geometrisch-konstruktive Ausgestaltung des Referenzobjekts, d. h. insbesondere Konstruktionsdaten, z. B. CAD-Daten, des Referenzobjekts. Die geometrisch-konstruktive Ausgestaltung, d. h. insbesondere auch die Masse, des Referenzobjekts ist typischerweise im Hinblick auf einen objektspezifischen Anwendungs- bzw. Einsatzbereich festgelegt.

Neben der Referenzobjektinformation wird, wie erwähnt, auch eine Randbedingungsinformation erstellt bzw. vorgegeben. Die Randbedingungsinformation beschreibt unterschiedliche das herzustellende Objekt 2 betreffende Randbedingungen. Randbedingungen können geometrisch-konstruktive Parameter bzw. strukturelle-physikalische Parameter bzw. Eigenschaften des herzustellenden Objekts 2 sein. Über die Randbedingungsinformation werden sonach bestimmte geometrisch-konstruktive Parameter bzw. bestimmte strukturelle-physikalische Parameter bzw. Eigenschaften vorgegeben, die an wenigstens einem Objektabschnitt des herzustellenden Objekts 2 bzw. dem gesamten herzustellenden Objekt 2 (zwingend) gegeben sein sollen.

Entsprechende Randbedingungen definieren wenigstens einen geometrisch-konstruktiven Parameter wenigstens eines äußeren (freiliegenden) Objektabschnitts des herzustellenden Objekts 2, z. B. einer Oberfläche, einer Seitenfläche, einer Bodenfläche, etc., und/oder wenigstens eines inneren (nicht freiliegenden) Objektabschnitts des herzustellenden Objekts 2 bzw. geometrisch-konstruktive Parameter des gesamten herzustellenden Objekts 2.

Entsprechende Randbedingungen können alternativ oder ergänzend wenigstens einen strukturellen bzw. physikalischen Parameter wenigstens eines äußeren (freiliegenden) Objektabschnitts des herzustellenden Objekts 2 und/oder wenigstens eines inneren (nicht freiliegenden) Objektabschnitts des herzustellenden Objekts 2 bzw. wenigstens einen strukturellen bzw. physikalischen Parameter des gesamten herzustellenden Objekts definieren. Entsprechende strukturelle bzw. physikalische Parameter sind insbesondere mechanische Parameter, wie z. B. Masse, Dichte, Härte, Festigkeit bzw.

Biegefestigkeit, Steifigkeit bzw. Biegesteifigkeit, Elastizität, Plastizität (Duktilität), Zähigkeit, und/oder tribologische Parameter, wie z. B. Reibzahl, Verschleißwiderstand, und/oder optisch-akustische Parameter, wie z. B. Licht- und/oder Schallabsorption bzw. Licht- und/oder Schallreflexion, und/oder thermische Parameter, wie z. B. thermische Ausdehnung, thermische Leitfähigkeit, (spezifische) Wärmekapazität, Warmfestigkeit, Kaltzähigkeit, und/oder elektrische Parameter, wie z. B. elektrische Leitfähigkeit, elektrischer Widerstand, wenigstens eines Objektabschnitts des herzustellenden Objekts bzw. des gesamten herzustellenden Objekts 2.

Die Randbedingungsinformation kann z. B. im Hinblick auf die durch die Referenzobjektinformation beschriebenen geometrisch-konstruktiven Daten des Referenzobjekts nicht zu verändernde bzw. nicht veränderbare zwei- oder dreidimensionale Bereiche des herzustellenden Objekts 2 beschreiben bzw. definieren. Das Objekt 2 wird dann mit den durch die Randbedingungsinformation beschriebenen nicht veränderbaren Bereichen entsprechenden Bereichen hergestellt.

Die Randbedingungsinformation kann z. B. eine geschlossene Außenkontur des herzustellenden Objekts 2 beschreiben bzw. definieren. Das Objekt 2 wird dann mit einer der durch die Randbedingungsinformation beschriebenen geschlossenen Außenkontur entsprechenden geschlossenen Außenkontur hergestellt.

Die Randbedingungsinformation kann ferner z. B. massiv auszubildende Außen- und/oder Innenbereiche des herzustellenden Objekts 2 beschreiben bzw. definieren. Das Objekt 2 wird dann den durch die Randbedingungsinformation beschriebenen massiv auszubildenden Außen- und/oder Innenbereichen entsprechenden massiv ausgebildeten Außen- und/oder Innenbereichen hergestellt.

Die Randbedingungsinformation kann ferner wenigstens ein im Hinblick auf eine bestimmungsgemäße Verwendung des herzustellenden Objekts 2 objektspezifisches Funktionsbereich oder -element, z. B. einen Verbindungsbereich oder ein Verbindungselement zum Verbinden des Objekts 2 mit einem weiteren Objekt, beschreiben bzw. definieren. Das Objekt 2 wird dann mit einem dem wenigstens einen durch die Randbedingungsinformation beschriebenen Funktionsbereich oder -element entsprechenden Funktionsbereich oder -element hergestellt.

In dem anhand der Fig. 2 - 7 erläuterten Ausführungsbeispiel ist durch die Randbedingungsinformation insbesondere beschrieben bzw. definiert, dass (i) eine vordere Spitze 9 (in Fig. 2 an den entsprechenden Objektabschnitten des Referenzobjekts gezeigt) des Objekts 2 zumindest mit den Objektabschnitten 10, 11 zusammenhängend ausgebildet werden muss, (ii) die geometrisch-konstruktive Gestaltung des Objektabschnitts 11 erhalten bleiben muss, (iii) die (freiliegenden) äußeren Flächen des Objekts 2 geschlossen sein müssen und (iv) das Objekt 2 im Vergleich zu dem Referenzobjekt in seiner geometrisch-konstruktiven Ausgestaltung nicht gekürzt werden darf. Durch die Randbedingungsinformation ist ferner definiert, dass (v) das Objekt 2 derart hergestellt sein soll, dass auf dieses bei bestimmungsgemäßer Verwendung wirkende mechanische Lasten insbesondere als Drucklasten aufgenommen werden, (vi) der Bereich der Spitze 9 des Objekts 2 mit einer konturnahen Temperierkanalstruktur versehen sein muss und (vii) alle für die Temperierung des Objekts 2 nicht notwendigen Objektabschnitte, insbesondere Bohrungen, entfernt werden dürfen.

In einem auf den ersten Schritt folgenden zweiten Schritt des Verfahrens wird eine wenigstens einen Lastwert in wenigstens einer bestimmten Lastsituation innerhalb des durch die Referenzobjektinformation beschriebenen Referenzobjekts beschreibende Lastinformation ermittelt (vgl. Fig. 3). Die Lastinformation beschreibt Lastwerte, welche wenigstens ein Referenzobjektabschnitt bzw. das gesamte Referenzobjekt in bestimmten Lastsituationen erfährt, und somit das Verhalten ("Lastverhalten") wenigstens eines Referenzobjektabschnitts bzw. des gesamten Referenzobjekts in bestimmten Lastsituationen. Bei entsprechenden Lastsituationen handelt es sich z. B. um bestimmungsgemäße Lastszenarien des herzustellenden Objekts 2, d. h. Lastsituationen, welchen das herzustellende Objekt 2 bei bestimmungsgemäßer Verwendung typischerweise ausgesetzt ist.

Die Lastinformation kann im Allgemeinen eine mechanische und/oder eine klimatische und/oder eine strömungstechnische und/oder eine thermische Lastsituation, insbesondere bei bestimmungsgemäßer Verwendung des herzustellenden Objekts 2, beschreiben. Die Lastinformation wird durch geeignete Algorithmen, vermittels einer rechnerbasierten Simulation, z. B. einer FEM-Simulation, erstellt. Mit anderen Worten beinhaltet die Lastinformation Daten einer Simulation, z. B. einer FEM-Simulation, vgl. Fig. 3.

Anhand von Fig. 3 ist ersichtlich, dass nur ein geringer Anteil des Referenzobjekts unter der gegebenen mechanischen Lastsituation mechanisch belastet ist. Anhand von Fig. 3 kann insofern abgeschätzt werden, dass ein vergleichsweise hohes Potential an Reduzierung von Baumaterial und somit ein vergleichsweise hohes Potential an Reduzierung des Gewichts des Objekts 2 möglich ist.

In einem auf den zweiten Schritt folgenden dritten Schritt des Verfahrens werden Lastbereiche mit von einem vorgebbaren oder vorgegebenen Referenzlastwert abweichenden Lastwerten innerhalb des Referenzobjekts anhand der Lastinformation bzw. in der Lastinformation ermittelt. Die in dem zweiten Schritt des Verfahrens ermittelten Lastwerte innerhalb des Referenzobjekts in der jeweils betrachteten Lastsituation werden sonach einzeln, gruppenweise oder vollständig mit wenigstens einem Referenzlastwert verglichen. Es wird sonach durch Ab- bzw. Vergleich ermittelt, ob entsprechende Lastwerte innerhalb des Referenzobjekts oberhalb oder unterhalb eines entsprechenden Referenzlastwerts liegen. Unter einem Referenzlastwert kann ein oberer und/oder unterer Lastgrenzwert zu verstehen sein. Obere bzw. untere Lastgrenzwerte sind typischerweise durch objektspezifische, insbesondere materialspezifische, Kennwerte definiert.

Das Ermitteln entsprechender Lastbereiche mit von einem Referenzlastwert abweichenden Lastwerten innerhalb des Referenzobjekts anhand der Lastinformation bzw. in der Lastinformation erfolgt durch geeignete Algorithmen, vermittels einer rechnerbasierten Simulation, z. B. einer FEM-Simulation.

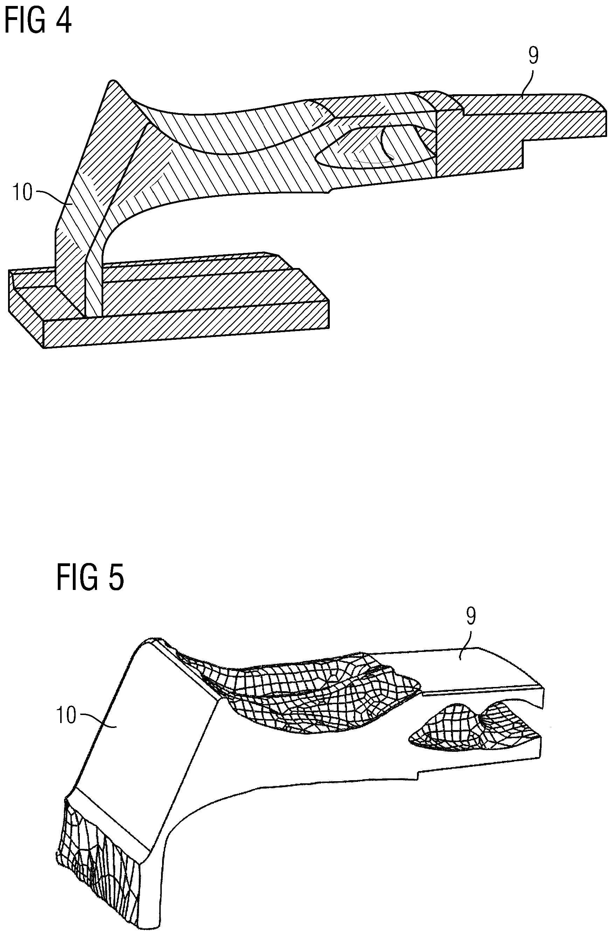

In Fig. 4 ist eine FEM-Simulation der der geometrisch-konstruktiven Ausgestaltung des Referenzobjekts nach einer Anpassung dieser an die Lastsituation gezeigt. Die unterschiedlichen Schraffuren zeigen unterschiedliche Lasten an. In Fig. 5 ist ein entsprechendes CAD-Modell gezeigt. Ersichtlich ist die geometrisch-konstruktive Ausgestaltung des Referenzobjekts im Vergleich zu der in Fig. 2 Gezeigten erheblich verändert. Zwar ist derart eine deutliche Gewichts- bzw. Materialreduzierung möglich, die vorstehend genannten Randbedingungen sind jedoch nicht erfüllt.

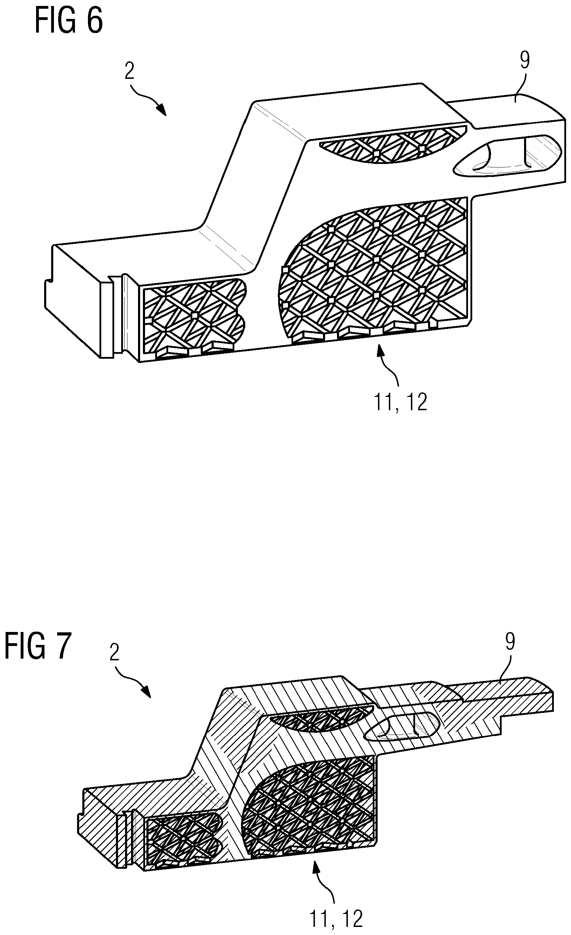

In einem auf den dritten Schritt folgenden vierten Schritt des Verfahrens wird auf Grundlage der Lastinformation sowie der Randbedingungsinformation eine geometrisch-konstruktive Daten des herzustellenden Objekts 2 beschreibende Objektinformation ermittelt. Entsprechende geometrisch-konstruktive Daten beinhalten die geometrisch-konstruktive Ausgestaltung des herzustellenden Objekts 2, vgl. Fig. 6.

In die geometrisch-konstruktive Ausgestaltung des herzustellenden Objekts 2 gehen die durch die Randbedingungsinformation beschriebenen bzw. definierten Randbedingungen ein. Gleichermaßen gehen die durch die Lastinformation beschriebenen Lastwerte in die Objektinformation ein.

Anhand von Fig. 6 ist zu erkennen, dass die Objektinformation Konstruktionsdaten, z. B. CAD-Daten, des herzustellenden Objekts 2 beschreibt. Diese Konstruktionsdaten werden in die geometrisch-konstruktive Gestalt, d. h. insbesondere die schichtbezogenen Querschnittsgeometrien, des herzustellenden Objekts 2 beschreibende Baudaten umgesetzt.

Anhand von Fig. 6 ist ferner zu erkennen, dass in jeweiligen Bereichen des herzustellenden Objekts 2, welche den Lastbereichen des Referenzobjekts, in welchen Lastwerte von entsprechenden Referenzlastwerten abweichen, entsprechen, besondere generativ aufgebaute äußere und/oder innere Strukturen ausgebildet werden, welche der jeweiligen Abweichung der jeweiligen Lastwerte von entsprechenden Referenzlastwerten Rechnung tragen.

In einem auf den vierten Schritt folgenden fünften Schritt des Verfahrens wird das Objekt 2 auf Grundlage der Objektinformation hergestellt. Das Objekt 2 wird dabei zumindest in den Lastbereichen mit von dem Referenzlastwert abweichenden Lastwerten durch sukzessives selektives schichtweises Verfestigen eines verfestigbaren Baumaterials generativ hergestellt. In dem Ausführungsbeispiel wird das gesamte Objekt 2 generativ aufgebaut.

Das Objekt 2 wird in Lastbereichen mit von dem Referenzlastwert abweichenden Lastwerten mit einer generativ gebildeten, wenigstens ein Leichtbauelement umfassenden Leichtbaustruktur 12 hergestellt. Durch die gezielte generative Ausbildung der Leichtbaustruktur 12 wird das Objekt 2 in Bereichen, welche entsprechenden Lastbereichen des Referenzobjekts entsprechen, welche bestimmte Referenzlastwerte über- oder unterschreiten, gezielt mit generativ ausgebildeten Strukturen hergestellt, die durch eine (lokale) Dichtereduzierung eine Gewichts- bzw. Materialreduzierung bewirken. Die Leichtbaustruktur 12 wird in mechanisch kaum beanspruchten Bereichen des Objekts 2 ausgebildet. Als Leichtbauelement einer entsprechenden Leichtbaustruktur 12 kann z. B. eine Aussparung, eine Sandwichstruktur, ein Bereich mit einer im Vergleich zu übrigen Bereichen des hergestellten Objekts 2 geringeren Dichte, ein Bereich aus einem im Vergleich zu einem übrigen verfestigbaren Baumaterial 3 des hergestellten Objekts 2 eine geringere Dichte aufweisenden verfestigbaren Baumaterial 3 oder ein Bereich mit einer im Vergleich zu übrigen Bereichen des hergestellten Objekts 2 geringeren Wandstärke gebildet werden.

Das Objekt 2 wird in Lastbereichen mit von dem Referenzlastwert abweichenden Lastwerten mit einer generativ gebildeten Temperierkanalstruktur (nicht gezeigt), welche von einem Temperiermedium zum Temperieren des hergestellten Objekts 2 durchströmbar ist, hergestellt. Durch die gezielte generative Ausbildung entsprechender Temperierkanalstrukturen kann das Objekt 2 in Bereichen, welche entsprechenden (thermischen) Lastbereichen des Referenzobjekts entsprechen, welche bestimmte (thermische) Referenzlastwerte über- oder unterschreiten, gezielt mit generativ ausgebildeten Strukturen hergestellt werden, die von einem Temperiermedium durchströmt eine Temperierung des Objekts 2 bewirken. Temperierkanalstrukturen werden typischerweise in thermisch beanspruchten Bereichen des Objekts 2 ausgebildet. Über entsprechende Temperierkanalstrukturen kann eine gezielte Temperierung, d. h. Kühlung oder Erwärmung, des Objekts 2 realisiert werden.

Das Objekt 2 wird in Lastbereichen mit von dem Referenzlastwert abweichenden Lastwerten mit einer generativ gebildeten, wenigstens ein Versteifungselement umfassenden Versteifungsstruktur 13 hergestellt. Durch die gezielte generative Ausbildung der Versteifungsstruktur 1 kann das Objekt 2 in Bereichen, welche entsprechenden (mechanischen) Lastbereichen des Referenzobjekts entsprechen, welche bestimmte (mechanische) Referenzlastwerte über- oder unterschreiten, gezielt mit generativ ausgebildeten Strukturen hergestellt werden, die durch eine (lokale) Versteifung eine Erhöhung der mechanischen Stabilität des Objekts 2 bewirken. Als Versteifungsbauelement kann z. B. ein Verrippungselement gebildet werden, vgl. Fig. 6. Die Versteifungsstruktur 12 kann dreidimensionale Längs- und/oder Querverrippung gebildet werden.

Das Objekt 2 kann in Lastbereichen mit von dem Referenzlastwert abweichenden Lastwerten mit einer generativ gebildeten, wenigstens ein bionisches Element, welches wenigstens eine biologische, insbesondere tierische und/oder pflanzliche, Struktur beschreibt und/oder aus wenigstens einer biologischen, insbesondere tierischen und/oder pflanzlichen, Struktur abgeleitet ist, umfassenden bionischen Struktur (nicht gezeigt) hergestellt werden. Als bionisches Element kann eine tierische Struktur, wobei als tierische Strukturen äußere und/oder innere Tierstrukturen und/oder tierisch erzeugte Strukturen, verwendet werden, und/oder eine pflanzliche Struktur, wobei als pflanzliche Strukturen äußere und/oder innere Pflanzenstrukturen und/oder pflanzlich erzeugte Strukturen verwendet werden, gebildet werden.

Generativ gebildete Strukturen, d. h. insbesondere Leichtbaustrukturen 12 und/oder Temperierkanalstrukturen und/oder Versteifungsstrukturen 13 und/oder bionische Strukturen, können sich zwei- oder dreidimensional, gegebenenfalls netzwerkartig, durch das Objekt 2 erstrecken. Entsprechende generativ gebildete Strukturen können sich (nur) durch das Innere des Objekts 2 erstrecken, so dass sie von außen nicht sichtbar sind. Entsprechende Strukturen können neben ihrer jeweils originären Funktion selbstverständlich auch (weitere) physikalische Eigenschaften des Objekts 2 beeinflussen. Dies kann z. B. bei einer, gegebenenfalls dreidimensionalen, Rippenstruktur innerhalb des Objekts 2 gegeben sein, welche einerseits (im Vergleich zu einer massiven Ausbildung) eine Materialreduktion und andererseits eine mechanische Versteifung des Objekts 2 bedingt.

Das Verfahren ermöglicht es, das Objekt 2, insbesondere im Hinblick auf bestimmte Lastsituationen des Objekts 2, gezielt generativ, d. h. insbesondere mit generativ ausgebildeten Strukturen, herzustellen. Dem Aufbau des Objekts 2 wird die vorherige Ermittlung bestimmter Lastbereiche in dem Referenzobjekt zugrunde gelegt, welche, wie beschrieben, im Hinblick auf bestimmte Referenzlastwerte ausgewertet, d. h. mit entsprechenden Referenzlastwerten verglichen, wurden. Derart können - bezogen auf eine bestimmte Lastsituation - Bereiche ermittelt werden, welche im Hinblick auf die bestimmte Lastsituation besonders, d. h. z. B. mit besonderen Strukturen, d. h. insbesondere optimiert, ausgebildet werden. Hierunter kann, wie erwähnt, z. B. eine Ausbildung von mechanischen Verstärkungsstrukturen und/oder eine Ausbildung von mechanischen Schwächungsstrukturen, d. h. z. B. Gewicht- bzw. Materialeinsparungsstrukturen und/oder eine Ausbildung von Temperierkanalstrukturen, etc. verstanden werden.

Das Objekt 2 ist sonach im Hinblick auf eine bestimmte Anwendungssituation bzw. eine bestimmte Lastsituation optimiert, was die strukturellen Eigenschaften des Objekts 2 unter verschiedenen Gesichtspunkten, z. B. mechanische Stabilität, Gewicht, etc., erheblich verbessert. Dabei ist es insbesondere möglich, dass eine entsprechende Optimierung nur im Inneren des Objekts 2 erfolgt. Die Außenabmessungen bzw. die Außenkontur, d. h. (im Wesentlichen) die äußere Form, des Objekts 2 kann (im Vergleich zu dem Referenzobjekt) beibehalten werden.

Ein weiterer Vorteil des Verfahrens liegt darin, dass verfahrensgemäß herzustellende Objekte 2 vollständig generativ aufgebaut werden können. Insbesondere im Hinblick auf die Herstellung von technischen Objekten, d. h. Werkzeugelementen für Spritzgießwerkzeuge, wie z. B. Werkzeugeinsatzelemente, Schieberelemente, etc., welche bis dato einen in einem Lager vorzuhaltenden Grundobjektkörper umfassen, welcher im Weiteren mit wenigstens einem generativ auf dem Grundobjektkörper aufgebauten Objektabschnitt versehen wird ("Hybridobjekt"), kann durch die direkte generative Herstellung des Objekts 2 Lagerplatz, Lagerzeit, Lagerarbeiten, etc. eingespart werden.

Fig. 7 zeigt schließlich eine Darstellung einer FEM-Simulation des auf Grundlage der Objektinformation herzustellenden bzw. hergestellten Objekts 2. Die unterschiedlichen Schraffuren zeigen unterschiedliche Lasten an. Es ist zu erkennen, dass eine Tragstruktur des Objekts 2 in ähnlicher Weise belastet ist, wie bei der in Fig. 4 gezeigten Darstellung. Die Leichtbaustruktur 12 ist weitgehend unbelastet. Die Leichtbaustruktur 12 ist jedoch zweckmäßig, um bestimmte im Betrieb des Objekts 2 entstehende Lasten, z. B. beim Einspannen des Objekts 2 in eine Spannaufnahme, aufzunehmen.

Mit dem anhand der Fig. 2 - 7 erläuterten Ausführungsbeispiel konnte das Gewicht des Objekts 2 bei gleicher geometrisch-konstruktiver Ausgestaltung und gleicher Funktionalität im Vergleich zu dem (massiven) Referenzobjekt um mehr als 50% reduziert werden. Durch Anpassung bestimmter Randbedingungen ließe sich eine weitere Reduzierung des Gewichts des Objekts 2 herbeiführen.

### BEZUGSZEICHENLISTE

- 1: Vorrichtung
- 2: Objekt
- 3: Baumaterial
- 4: Strahlungserzeugungseinrichtung
- 5: Energiestrahl
- 6: Strahlablenkeinrichtung
- 7: Beschichtungseinrichtung
- 8: Baukammer
- 9: Spitze
- 10: Objektabschnitt
- 11: Objektabschnitt
- 12: Leichtbaustruktur
- 13: Versteifungsstruktur

## Patentansprüche

1. Verfahren zur Herstellung eines dreidimensionalen Objekts (2), wobei das Objekt ein Werkzeugelement eines Spritzgießwerkzeugs ist, mit den Schritten:
- Vorgabe einer, insbesondere geometrisch-konstruktive, Daten eines Referenzobjekts beschreibenden Referenzobjektinformation, wobei die geometrisch-konstruktive Ausgestaltung des Referenzobjekts im Hinblick auf einen objektspezifischen Anwendungs- oder Einsatzbereich festgelegt ist, sowie wenigstens einer wenigstens eine, insbesondere geometrisch-konstruktive, Randbedingung des herzustellenden Objekts (2) beschreibenden Randbedingungsinformation, wobei entsprechende durch die Referenzobjektinformation beschriebene geometrisch-konstruktive Daten des Referenzobjekts eine abzuwandelnde oder zu optimierende Grundform des eigentlich herzustellenden Objekts beschreiben,
- Ermitteln einer wenigstens einen Lastwert in einer bestimmten Lastsituation innerhalb des durch die Referenzobjektinformation beschriebenen Referenzobjekts beschreibenden Lastinformation vermittels einer rechnerbasierten Simulation,
- Ermitteln von Lastbereichen mit von einem Referenzlastwert abweichenden Lastwerten innerhalb des durch die Referenzobjektinformation beschriebenen Referenzobjekts anhand der Lastinformation vermittels einer rechnerbasierten Simulation,
- Ermitteln einer geometrisch-konstruktive Daten des herzustellenden dreidimensionalen Objekts (2) beschreibenden Objektinformation auf Grundlage der Lastinformation sowie der Randbedingungsinformation,
- Herstellen des herzustellenden dreidimensionalen Objekts (2) auf Grundlage der Objektinformation, wobei das herzustellende dreidimensionale Objekt (2) zumindest in Lastbereichen mit von dem Referenzlastwert abweichenden Lastwerten durch sukzessives selektives schichtweises Verfestigen eines verfestigbaren Baumaterials (3) generativ hergestellt wird, wobei das herzustellende dreidimensionale Objekt (2) in Lastbereichen mit von dem Referenzlastwert abweichenden Lastwerten mit einer durch sukzessives selektives schichtweises Verfestigen des verfestigbaren Baumaterials (3) vermittels des von der Strahlungserzeugungseinrichtung (4) erzeugten Energiestrahls (5) generativ gebildeten Temperierkanalstruktur, welche von einem Temperiermedium zum Temperieren des hergestellten dreidimensionalen Objekts (2) durchströmbar ist, hergestellt wird.

2. Verfahren nach Anspruch 1, wobei das herzustellende dreidimensionale Objekt (2) in Lastbereichen mit von dem Referenzlastwert abweichenden Lastwerten mit einer durch sukzessives selektives schichtweises Verfestigen des verfestigbaren Baumaterials (3) vermittels des von der Strahlungserzeugungseinrichtung (4) erzeugten Energiestrahls (5) generativ gebildeten, wenigstens ein Leichtbauelement umfassenden Leichtbaustruktur (12) hergestellt wird.

3. Verfahren nach Anspruch 2, wobei als Leichtbauelement eine Aussparung, eine Sandwichstruktur, ein Bereich mit einer im Vergleich zu übrigen Bereichen des hergestellten dreidimensionalen Objekts (2) geringeren Dichte, ein Bereich aus einem im Vergleich zu einem übrigen verfestigbaren Baumaterial (3) des hergestellten dreidimensionalen Objekts (2) eine geringere Dichte aufweisenden verfestigbaren Baumaterial (3) oder ein Bereich mit einer im Vergleich zu übrigen Bereichen des hergestellten dreidimensionalen Objekts (2) geringeren Wandstärke gebildet wird.

4. Verfahren nach einem der vorhergehenden Ansprüche, wobei das herzustellende dreidimensionale Objekt (2) in Lastbereichen mit von dem Referenzlastwert abweichenden Lastwerten mit einer durch sukzessives selektives schichtweises Verfestigen des verfestigbaren Baumaterials (3) vermittels des von der Strahlungserzeugungseinrichtung (4) erzeugten Energiestrahls (5) generativ gebildeten, wenigstens ein Versteifungselement umfassenden Versteifungsstruktur (13) hergestellt wird.

5. Verfahren nach Anspruch 4, wobei als Versteifungsbauelement ein Verrippungselement, insbesondere innerhalb des hergestellten dreidimensionalen Objekts (2), gebildet wird.

6. Verfahren nach einem der vorhergehenden Ansprüche, wobei das herzustellende dreidimensionale Objekt (2) in Lastbereichen mit von dem Referenzlastwert abweichenden Lastwerten mit einer durch sukzessives selektives schichtweises Verfestigen des verfestigbaren Baumaterials (3) vermittels des von der Strahlungserzeugungseinrichtung (4) erzeugten Energiestrahls (5) generativ gebildeten, wenigstens ein bionisches Element, welches wenigstens eine biologische, insbesondere tierische und/oder pflanzliche, Struktur beschreibt und/oder aus wenigstens einer biologischen, insbesondere tierischen und/oder pflanzlichen, Struktur abgeleitet ist, umfassenden bionischen Struktur hergestellt wird.

7. Verfahren nach Anspruch 6, wobei als bionisches Elemente eine tierische Struktur, wobei als tierische Strukturen äußere und/oder innere Tierstrukturen und/oder tierisch erzeugte Strukturen, verwendet werden, gebildet wird,
und/oder als bionisches Elemente eine pflanzliche Struktur, wobei als pflanzliche Strukturen äußere und/oder innere Pflanzenstrukturen und/oder pflanzlich erzeugte Strukturen verwendet werden, gebildet wird.

8. Verfahren nach einem der vorhergehenden Ansprüche, wobei die Randbedingungsinformation wenigstens einen im Hinblick auf durch die Referenzobjektinformation beschriebenen geometrisch-konstruktiven Daten des Referenzobjekts nicht veränderbaren Bereich des herzustellenden dreidimensionalen Objekts (2) beschreibt und das herzustellende dreidimensionale Objekt (2) mit einem dem durch die Randbedingungsinformation beschriebenen nicht veränderbaren Bereich entsprechenden Bereich hergestellt wird.

9. Verfahren nach einem der vorhergehenden Ansprüche, wobei die Randbedingungsinformation eine zumindest abschnittsweise geschlossene Außenkontur des herzustellenden dreidimensionalen Objekts (2) beschreibt und das herzustellende dreidimensionale Objekt (2) mit einer der durch die Randbedingungsinformation beschriebenen zumindest abschnittsweise geschlossenen Außenkontur entsprechenden zumindest abschnittsweise geschlossenen Außenkontur hergestellt wird.

10. Verfahren nach einem der vorhergehenden Ansprüche, wobei die Randbedingungsinformation wenigstens einen massiven Außen- und/oder Innenbereich des herzustellenden dreidimensionalen Objekts (2) beschreibt und das herzustellende dreidimensionale Objekt (2) mit einem dem durch die Randbedingungsinformation beschriebenen massiven Außen- und/oder Innenbereich entsprechenden massiven Außen- und/oder Innenbereich hergestellt wird.

11. Verfahren nach einem der vorhergehenden Ansprüche, wobei die Randbedingungsinformation wenigstens ein im Hinblick auf eine bestimmungsgemäße Verwendung des herzustellenden dreidimensionalen Objekts (2) objektspezifisches Funktionselement beschreibt, wobei das herzustellende dreidimensionale Objekt (2) mit einem dem wenigstens einen durch die Randbedingungsinformation beschriebenen Funktionselement entsprechenden Funktionselement hergestellt wird.

12. Verfahren nach einem der vorhergehenden Ansprüche, wobei die Lastinformation eine mechanische und/oder eine klimatische und/oder eine strömungstechnische und/oder thermische Lastsituation, insbesondere bei bestimmungsgemäßer Verwendung des herzustellenden dreidimensionalen Objekts (2), beschreibt.

13. Verfahren nach einem der vorhergehenden Ansprüche, wobei als Werkzeugelement eines Spritzgießwerkzeugs ein Schieberelement oder ein Werkzeugeinsatzelement hergestellt wird.

14. Vorrichtung (1) zur generativen Herstellung eines dreidimensionalen Objekts (2) durch sukzessive schichtweise selektive Verfestigung eines verfestigbaren Baumaterials (3) vermittels eines von einer Strahlungserzeugungseinrichtung (4) erzeugten Energiestrahls (5), wobei die Vorrichtung (1) eine Steuereinrichtung zur Durchführung des Verfahrens nach einem der vorhergehenden Ansprüche aufweist.

## Claims

1. A method for producing a three-dimensional object (2), wherein the object is a tool element of an injection moulding tool,
comprising the steps:
- providing an item of reference object information describing in particular geometric structural data of a reference object, wherein the geometric structural design of the reference object is defined with regard to an object-specific area of application or use, and at least one item of boundary condition information describing at least one in particular geometric structural boundary condition of the object (2) to be produced, wherein corresponding geometric structural data of the reference object described by the item of reference object information describe a basic form of the object to be actually produced that is to be modified or optimized,
- determining an item of load information describing at least one load value in a specific load situation within the reference object described by the item of reference object information, by way of a computer-based simulation,
- determining, from the item of load information, load regions within the reference object described by the item of reference object information with load values deviating from a reference load value, by way of a computer-based simulation,
- determining an item of object information describing geometric structural data of the three-dimensional object (2) to be produced, on the basis of the item of load information and the item of boundary condition information,
- producing the three-dimensional object (2) to be produced on the basis of the item of object information, wherein the three-dimensional object (2) to be produced, at least in load regions with load values deviating from the reference load value, is additively produced by successive selective layer-by-layer solidification of a solidifiable construction material (3), wherein, in load regions with load values deviating from the reference load value, the three-dimensional object (2) to be produced is produced with a temperature-control channel structure additively formed by successive selective layer-by-layer solidification of the solidifiable construction material (3) by way of the energy beam (5) generated by the radiation-generating device (4), through which channel structure a temperature-control medium for controlling the temperature of the produced three-dimensional object (2) can flow.

2. The method according to claim 1, wherein, in load regions with load values deviating from the reference load value, the three-dimensional object (2) to be produced is produced with a lightweight structure (12) comprising at least one lightweight construction element and additively formed by successive selective layer-by-layer solidification of the solidifiable construction material (3) by way of the energy beam (5) generated by the radiation-generating device (4).

3. The method according to claim 2, wherein a recess, a sandwich structure, a region with a lower density compared to other regions of the produced three-dimensional object (2), a region made of a solidifiable construction material (3) having a lower density compared to another solidifiable construction material (3) of the produced three-dimensional object (2), or a region with a smaller wall thickness compared to other regions of the produced three-dimensional object (2) is formed as the lightweight construction element.

4. The method according to one of the preceding claims, wherein, in load regions with load values deviating from the reference load value, the three-dimensional object (2) to be produced is produced with a reinforcing structure (13) comprising at least one reinforcing element additively formed by successive selective layer-by-layer solidification of the solidifiable construction material (3) by way of the energy beam (5) generated by the radiation-generating device (4).

5. The method according to claim 4, wherein a ribbed element is formed as the reinforcing construction element, in particular inside the produced three-dimensional object (2).

6. The method according to one of the preceding claims, wherein, in load regions with load values deviating from the reference load value, the three-dimensional object (2) to be produced is produced with a bionic structure which comprises at least one bionic element that describes at least one biological, in particular animal and/or vegetable, structure and/or is derived from at least one biological, in particular animal and/or vegetable, structure and which is additively formed by successive selective layer-by-layer solidification of the solidifiable construction material (3) by way of the energy beam (5) generated by the radiation-generating device (4).

7. The method according to claim 6, wherein an animal structure is formed as the bionic element, wherein external and/or internal animal structures and/or animal-generated structures are used as animal structures,
and/or a vegetable structure is formed as the bionic element, wherein external and/or internal vegetable structures and/or vegetable-generated structures are used as vegetable structures.

8. The method according to one of the preceding claims, wherein the item of boundary condition information describes at least one region of the three-dimensional object (2) to be produced that is non-changeable in terms of geometric structural data of the reference object described by the item of reference object information, and the three-dimensional object (2) to be produced is produced with a region corresponding to the non-changeable region described by the item of boundary condition information.

9. The method according to one of the preceding claims, wherein the item of boundary condition information describes an at least partially closed outer contour of the three-dimensional object (2) to be produced, and the three-dimensional object (2) to be produced is produced with an at least partially closed outer contour corresponding to the at least partially closed outer contour described by the item of boundary condition information.

10. The method according to one of the preceding claims, wherein the item of boundary condition information describes at least one solid external and/or internal region of the three-dimensional object (2) to be produced, and the three-dimensional object (2) to be produced is produced with a solid external and/or internal region corresponding to the solid external and/or internal region described by the item of boundary condition information.

11. The method according to one of the preceding claims, wherein the item of boundary condition information describes at least one functional element object-specific in terms of an intended use of the three-dimensional object (2) to be produced, wherein the three-dimensional object (2) to be produced is produced with a functional element corresponding to the at least one functional element described by the item of boundary condition information.

12. The method according to one of the preceding claims, wherein the item of load information describes a mechanical and/or a climatic and/or a fluidic and/or thermal load situation, in particular when the three-dimensional object (2) to be produced is used as intended.

13. The method according to one of the preceding claims, wherein a pusher element or a tool insert element is produced as the tool element of an injection moulding tool.

14. An apparatus (1) for additively producing a three-dimensional object (2) by successive selective layer-by-layer solidification of a solidifiable construction material (3) by way of an energy beam (5) generated by a radiation-generating device (4), wherein the apparatus (1) has a control device for carrying out the method according to one of the preceding claims.

## Revendications

1. Procédé de fabrication d'un objet tridimensionnel (2), dans lequel l'objet est un élément d'outil d'un outil de moulage par injection,
avec les étapes :
- de spécification d'une information d'objet de référence, en particulier de conception géométrique, décrivant des données d'un objet de référence, dans lequel la configuration de conception géométrique de l'objet de référence est fixée eu égard au domaine d'application ou d'utilisation spécifique à l'objet, ainsi que d'au moins une information de condition limite décrivant au moins une condition limite, en particulier de conception géométrique, de l'objet (2) à fabriquer, dans lequel des données correspondantes de conception géométrique, décrites par l'information d'objet de référence, de l'objet de référence décrivent une forme de base à transformer ou à optimiser de l'objet à fabriquer à proprement parler,
- de détermination d'une information de charge décrivant au moins une valeur de charge dans une situation de charge donnée à l'intérieur de l'objet de référence décrit par l'information d'objet de référence au moyen d'une simulation informatisée,
- de détermination de plages de charges avec des valeurs de charge divergeant d'une valeur de charge de référence à l'intérieur de l'objet de référence décrit par l'information d'objet de référence à l'aide de l'information de charge au moyen d'une simulation informatisée,
- de détermination d'une information d'objet décrivant des données de conception géométrique de l'objet tridimensionnel (2) à fabriquer sur la base de l'information de charge et de l'information de condition limite,
- de fabrication de l'objet tridimensionnel (2) à fabriquer sur la base de l'information d'objet, dans lequel l'objet tridimensionnel (2) à fabriquer est fabriqué de manière générative par solidification par couches sélective successive d'un matériau de construction (3) pouvant être solidifié au moins dans des plages de charges avec des valeurs de charge divergeant de la valeur de charge de référence, dans lequel l'objet tridimensionnel (2) à fabriquer est fabriqué , dans des plages de charges avec des valeurs de charge divergeant de la valeur de charge de référence, avec une structure de canal de thermorégulation formée de manière générative par solidification par couches sélective successive du matériau de construction (3) pouvant être solidifié au moyen du faisceau d'énergie (5) produit par le système de production de rayonnement (4), laquelle peut être traversée par un milieu de thermorégulation pour thermoréguler l'objet tridimensionnel (2) fabriqué.

2. Procédé selon la revendication 1, dans lequel l'objet tridimensionnel (2) à fabriquer est fabriqué dans des plages de charges avec des valeurs de charge divergeant de la valeur de charge de référence avec une structure de construction légère (12) formée de manière générative par solidification par couches sélective successive du matériau de construction (3) pouvant être solidifié au moyen du faisceau d'énergie (5) produit par le système de production de rayonnement (4), comprenant au moins un élément de construction légère.

3. Procédé selon la revendication 2, dans lequel un évidement, une structure en sandwich, une zone avec une densité inférieure en comparaison avec des zones restantes de l'objet tridimensionnel (2) fabriqué, une zone composée d'un matériau de construction (3) pouvant être solidifié présentant une densité inférieure en comparaison avec un matériau de construction (3) restant pouvant être solidifié de l'objet tridimensionnel (2) fabriqué ou une zone avec une épaisseur de paroi inférieure en comparaison avec des zones restantes de l'objet tridimensionnel (2) fabriqué est fourni/fournie en tant qu'élément de construction légère.

4. Procédé selon l'une quelconque des revendications précédentes, dans lequel l'objet tridimensionnel (2) à fabriquer est fabriqué, dans des plages de charges avec des valeurs de charge divergeant de la valeur de charge de référence, avec une structure de renforcement (13) formée de manière générative par solidification par couches sélective successive du matériau de construction (3) pouvant être solidifié au moyen du faisceau d'énergie (5) produit par le système de production de rayonnement (4), comprenant au moins un élément de renforcement.

5. Procédé selon la revendication 4, dans lequel un élément de nervurage est formé, en particulier à l'intérieur de l'objet tridimensionnel (2) fabriqué, en tant que composant de renforcement.

6. Procédé selon l'une quelconque des revendications précédentes, dans lequel l'objet tridimensionnel (2) à fabriquer est fabriqué, dans des plages de charges avec des valeurs de charge divergeant de la valeur de charge de référence, avec une structure bionique formée de manière générative par solidification par couches sélective successive du matériau de construction (3) pouvant être solidifié au moyen du faisceau d'énergie (5) produit par le système de production de rayonnement (4), comprenant au moins un élément bionique, lequel décrit au moins une structure biologique, en particulier animale et/ou végétale et/ou est dérivé d'au moins une structure biologique, en particulier animale et/ou végétale.

7. Procédé selon la revendication 6, dans lequel une structure animale est formée en tant qu'élément bionique, dans lequel des structures animales extérieures et/ou intérieures et/ou des structures produites d'origine animale sont utilisées en tant que structures animales,
et/ou une structure végétale est formée en tant qu'élément bionique, dans lequel des structures végétales extérieures et/ou intérieures et/ou des structures produites d'origine végétale sont utilisées en tant que structures végétales.

8. Procédé selon l'une quelconque des revendications précédentes, dans lequel l'information de condition limite décrit au moins une zone non modifiable, eu égard à des données de conception géométrique, décrites par l'information d'objet de référence, de l'objet de référence, de l'objet tridimensionnel (2) à fabriquer et l'objet tridimensionnel (2) à fabriquer est fabriqué avec une zone correspondant à la zone non modifiable décrite par l'information de condition limite.

9. Procédé selon l'une quelconque des revendications précédentes, dans lequel l'information de condition limite décrit un contour extérieur, au moins par endroits fermé, de l'objet tridimensionnel (2) à fabriquer et l'objet tridimensionnel (2) à fabriquer est fabriqué avec un contour extérieur fermé au moins par endroits, correspond au contour extérieur fermé au moins par endroits décrit par l'information de condition limite.

10. Procédé selon l'une quelconque des revendications précédentes, dans lequel l'information de condition limite décrit au moins une zone extérieure et/ou intérieure massive de l'objet tridimensionnel (2) à fabriquer et l'objet tridimensionnel (2) à fabriquer est fabriqué avec une zone extérieure et/ou intérieure massive correspondant à la zone extérieure et/ou intérieure massive décrite par l'information de condition limite.

11. Procédé selon l'une quelconque des revendications précédentes, dans lequel l'information de condition limite décrit au moins un élément fonctionnel spécifique à l'objet eu égard à une utilisation conforme à l'usage prévu de l'objet tridimensionnel (2) à fabriquer, dans lequel l'objet tridimensionnel (2) à fabriquer est fabriqué avec un élément fonctionnel correspondant à l'au moins un élément fonctionnel décrit par l'information de condition limite.

12. Procédé selon l'une quelconque des revendications précédentes, dans lequel l'information de charge décrit une situation de charge mécanique et/ou climatique et/ou de communication fluidique et/ou thermique, en particulier lors de l'utilisation conforme à l'usage prévu de l'objet tridimensionnel (2) à fabriquer.

13. Procédé selon l'une quelconque des revendications précédentes, dans lequel un élément de coulisseau ou un élément d'insert d'outil est fabriqué en tant qu'élément d'outil d'un outil de moulage par injection.

14. Dispositif (1) de fabrication générative d'un objet tridimensionnel (2) par solidification sélective par couches successive d'un matériau de construction (3) pouvant être solidifié au moyen d'un faisceau d'énergie (5) produit par un système de production de rayonnement (4), dans lequel le dispositif (1) présente un système de commande pour mettre en oeuvre le procédé selon l'une quelconque des revendications précédentes.
